# EUROPEAN PATENT APPLICATION

(11) **EP 3 026 551 A1**
(43) Date of publication of application: **01.06.2016**
(21) Application number: 14003995.9
(22) Date of filing: 26.11.2014
(51) Int. Cl.: G06F 9/445, G06F 9/45, H03M 7/30

(54) **Methods and devices for compressing byte code for smart cards**

(71) Applicant: Giesecke & Devrient GmbH, 81677 München (DE)
(72) Inventor: Jauernig, Matthias, 81669 München (DE); Simonin, Nicolas, 33050 Pozzuolo del Friuli (IT)

(57) **Abstract**

The invention relates to a method of providing a software application in compressed form to a computing device, wherein the software application comprises a plurality of methods that can be called from within the software application. The method com-prises the steps of: (a) assigning the methods of the plurality of methods to a first set of methods to be compressed and a second set of methods not to be compressed; (b) compressing the methods of the first set of methods; and (c) providing the software application in compressed form to the computing device, wherein the software application in compressed form comprises the methods of the second set of methods and the methods compressed in step (b). Moreover, the invention relates to corresponding computing devices as well as a corresponding method of executing the software application.

## Description

### Field of the Invention

The invention relates to methods and devices for compressing byte code for execution by a virtual machine implemented on a computing device. More specifically, the invention relates to methods and devices for compressing Java byte code for execution by a Java card virtual machine implemented on a smart card.

### Background of the Invention

Smart cards or chip cards are cards with embedded circuitry that provide a variety of functionality. Currently, smart cards are used as credit or debit cards, as secure elements for mobile phones, often in the form of SIM cards, authorization cards for pay television, access-control cards, electronic wallets, public transport payment cards, digital identification cards and for a wide variety of other purposes. The main reason for the use of smart cards in these different areas is that smart cards are engineered to be secure and tamper resistant.

In general, current smart cards are about the size of a credit card (although the card may be bigger or smaller depending on its function). The type and amount of embedded circuitry on a smart card also varies. A typical smart card in use today will include a small amount of volatile memory (up to a few KB), a slightly greater amount of non-volatile memory, and a small microprocessor.

Accordingly, software written for current smart cards has to be compact in order to execute in current smart cards' limited computing resource environments. An example of a software framework for developing and executing applications for current smart cards is the Java card technology. To make use of the limited resources on current smart cards, Java card provides an operating framework that includes an abridged version of the standard Java virtual machine, namely the Java card virtual machine ("JCVM"). The JCVM implements a subset of the standard Java virtual machine instructions.

The JCVM executes instructions defining a software application in the form of byte code. Generally, these instructions are stored in the memory of the smart card in an uncompressed form. However, as the instructions used are just a subset of the available set of instructions, the entropy of the byte code is low, so that compressing the byte code of a software application could lead to a significant reduction of the memory space used. A major drawback of compression on byte code level is, however, that the necessary uncompression step during runtime slows down the byte code execution speed potentially causing time critical software applications on the smart card to fail, such as a NFC payment application or the like.

Thus, there is a need for improved methods and devices for compressing byte code of a software application in an efficient manner.

### Summary of the Invention

The above object is achieved according to the present invention by the subject-matter of the independent claims. Preferred embodiments of the invention are defined in the dependent claims.

The present invention is based on the general idea to implement byte code compression on the level of methods such that there a methods which are compressed as a whole as well as methods which are not compressed. There is no partial compression of methods.

More specifically, according to a first aspect the invention provides a method of providing a software application in compressed form to a computing device, wherein the software application comprises a plurality of methods that can be called from within the software application. The method comprises the steps of: (a) assigning the methods of the plurality of methods to a first set of methods to be compressed and a second set of methods not to be compressed; (b) compressing the methods of the first set of methods; and (c) providing the software application in compressed form to the computing device, wherein the software application in compressed form comprises the methods of the second set of methods and the methods compressed in step (b).

Preferably, the method according to the first aspect of the invention comprises before step (b) of compressing the methods of the first set of methods the additional step of compiling the plurality of methods from source code into byte code.

According to preferred embodiments of the invention, step (a) of assigning the methods of the plurality of methods to a first set of methods to be compressed and a second set of methods not to be compressed is done automatically.

Preferably, in step (a) the methods of the plurality of methods are assigned to a first set of methods to be compressed and a second set of methods not to be compressed on the basis of predefined criteria, such as whether a given method of the plurality of methods is time critical, i.e. has to perform within certain time constraints during runtime, is called very frequently by other methods or classes of the software application and/ or provides critical functions implemented in an operating system of the computing device.

According to preferred embodiments of the invention, step (a) of assigning the methods of the plurality of methods to a first set of methods to be compressed and a second set of methods not to be compressed comprises the additional step of assigning the methods of the plurality of methods to one or more blocks to be compressed.

Preferably, the one or more blocks to be compressed have the same size.

According to preferred embodiments of the invention, the step of assigning the methods of the plurality of methods to one or more blocks to be compressed comprises the additional step of determining an optimal block size.

Preferably, the methods to be compressed are assigned in such a way to the one or more blocks to be compressed that during runtime the maximum number of method calls are calls to methods within the same block.

According to preferred embodiments of the invention, a method of the methods to be compressed that is called by other methods of the plurality of methods more often than a predefined threshold is assigned to more than one block of the one or more blocks.

Preferably, in step (b) the methods of the first set of methods are compressed using an entropy encoding, preferably Huffman coding.

According to a second aspect the present invention provides a computing device, preferably a smart card, comprising a software application in compressed form that has been provided to the computing device by one of the methods according to the first aspect of the invention.

According to a third aspect the present invention provides for a method of executing a software application on a computing device, wherein the software application is stored on the computing device in compressed form and comprises a plurality of methods that can be called from within the software application, including a first set of methods in compressed form and a second set of methods in uncompressed form, wherein the method comprises the step of: (a) executing the software application on the computing device.

Preferably, step (a) of executing the software application on the computing device includes the additional step of uncompressing at least one method of the first set of methods during runtime and storing the at least one method within a RAM of the computing device.

According to preferred embodiments of the present invention, step (b) of uncompressing at least one method of the first set of methods during runtime and storing the at least one method within a RAM of the computing device is done after the additional step of checking whether the at least one method has already been uncompressed.

According to a fourth aspect the present invention provides for a computing device that is configured to execute a software application according to one of the methods according to the third aspect of the present invention.

As the person skilled in the art will appreciate, the present invention provides, amongst others, for the following advantages. The byte code is compressed very efficiently in order to save as much memory space as possible. The step of uncompressing the compressed byte code does not require too many computational resources, especially RAM and on-card computing time and, thus, being executable on a smart card. Despite the byte code compression and the subsequent uncompression, time-critical applets or parts of the operating system (OS) can be executed sufficiently fast.

These and other features, characteristics, advantages, and objects of the invention will be clear from the following detailed description of preferred embodiments, given as a non-restrictive example, under reference to the attached drawings. The person skilled in the art will appreciate, in particular, that the above preferred embodiments can be combined in several ways, which will result in additional advantageous embodiments that are explicitly supported and covered by the present invention. In particular, the person skilled in the art will appreciate that the above described preferred embodiments can be implemented in the context of the different aspects of the invention.

### Brief description of the drawings

- Fig. 1: shows a schematic overview of a terminal in communication with a smart card implemented as a Java card that can be advantageously used within the context of the present invention;
- Fig. 2: shows a schematic overview of a preferred software architecture of the smart card of figure 1; and
- Fig. 3: shows a diagram illustrating a method for compressing the byte code of an applet implemented on the smart card of figures 1 and 2 according to a preferred embodiment of the present invention.

### Detailed description of preferred embodiments of the present invention

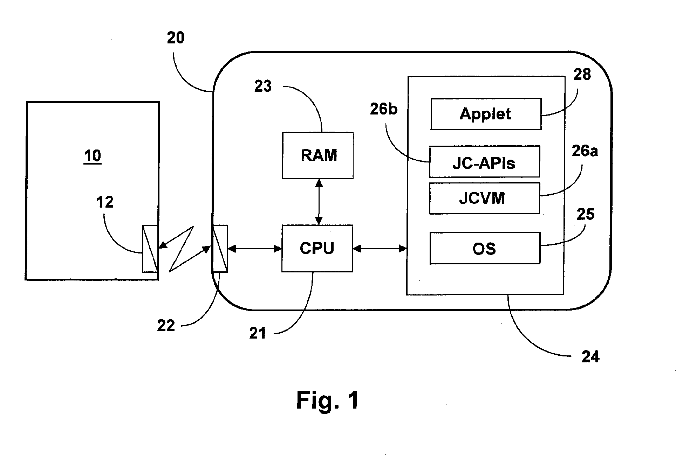

Figure 1 shows schematically a computing unit in the form of a smart card 20 in communication with a terminal 10. Preferably, the smart card 20 is implemented in the form of a Java card. However, as will be readily appreciated by the person skilled in the art from the below, the present invention can be implemented advantageously on smart cards and computing units in general using other operating environments.

Generally, the smart card 20 shown in figure 1 is configured to exchange data with the terminal 10. For exchanging data both the smart card 20 and the terminal 10 comprise appropriately configured communication interfaces 22 and 12, respectively. The communication interfaces 22 and 12 could be configured such that the communication between the smart card 20 and the terminal 10 is wireless, i.e. over-the-air, as schematically indicated in figure 1. Alternatively, the exchange of data between the smart card 20 and the terminal 10 could be by means of a wired connection. In this case the communication interface 22 is usually implemented as a contact area on the smart card's surface comprising several contact pads for data exchange with the terminal 10. Needless to say that the present invention can be advantageously employed also with smart cards that comprise both a communication interface for wired data exchange as well as a communication interface for wireless data exchange with a terminal, which are known as dual interface smart cards.

In addition to the communication interface 22 for data exchange with the terminal 10 the smart card 20 comprises a central processing unit (CPU) 21 which is communicatively connected with the communication interface 22. Moreover, the CPU 21 is communicatively connected with a random access memory (RAM) 23 as well as a non-volatile, rewritable memory 24. Preferably, the non-volatile, rewritable memory 24 is implemented as a flash memory, such as a flash memory having a NAND or a NOR architecture. In addition to a rewritable portion the non-volatile memory 24 could comprise a read only memory (ROM) portion as well (not shown in figure 1).

In the preferred embodiment of figure 1 program code is stored in the non-volatile memory 24 of the smart card 20 that can be executed by the processor 21. More specifically, the program code implementing the smart card operating system 25 is stored in the non-volatile memory 24. In addition to the operating system 25 the non-volatile memory 24 of the smart card 20 stores respective program code implementing a Java card virtual machine 26a (JCVM) including a plurality of Java card application programming interfaces (JC APIs; also known as class libraries) 26b as well as an application 28, as will be described in more detail further below. Preferably, the application 28 is implemented in the form of a Java card applet.

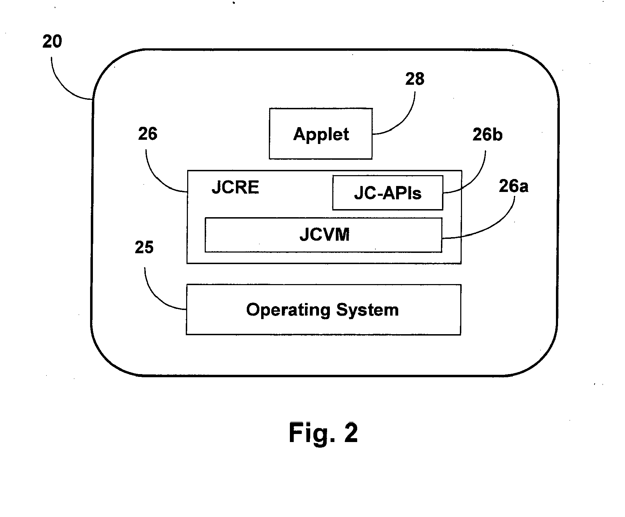

Figure 2 shows schematically a preferred software architecture of the smart card 20 of figure 1. A Java card runtime environment (JCRE) 26 operates on top of the native operating system 25 of the smart card 20. Generally, the native operating system 25 and the Java card runtime environment (JCRE) 26 are implemented on the smart card 20 by the manufacturer in the course of the production of the smart card 20.

The Java card runtime environment (JCRE) 26 comprises the Java card virtual machine 26a (JCVM) as well as the plurality of Java card APIs 26b already mentioned above in connection with figure 1. These Java card APIs 26b allow the applet 28 operating on top thereof to call functions provided by the software layers below, namely by the native operating system 25 and/ or the Java card virtual machine 26a (JCVM). For further details concerning the general software architecture of a conventional Java card reference is made to the book "Java Card Technology for Smart Cards", Zhiqun Chen, Addison-Wesley, 2000.

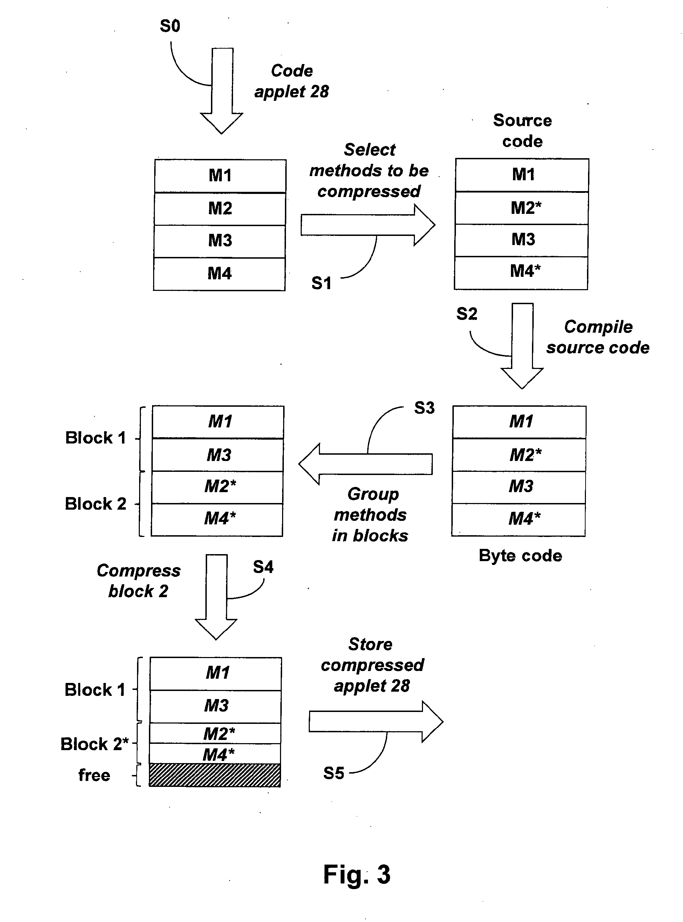

Figure 3 illustrates schematically a method for compressing the applet 28 shown in figures 1 and 2 and storing it in compressed form on the non-volatile memory 24 of the smart card 20 according to a preferred embodiment of the present invention. Although in the below a preferred embodiment of the present invention is illustrated in the context of a Java applet implemented on the smart card 20, the person skilled in the art will appreciate that the present invention can be advantageously put to practice on a computing unit different than a smart card and/or using a different programming language employing byte code.

In step S0 of figure 3 the Java applet 28 is coded, i.e. programmed, in Java source code. Generally, the development of a Java card applet, such as the Java applet 28, begins as with any other Java program. A developer programs or codes the Java applet 28 in the form of source code including one or more Java classes to be compiled with a Java compiler, producing one or more class files containing Java byte code. By way of example, the applet 28 includes the methods M1, M2, M3 and M4, as schematically illustrated in figure 3, in addition to the one or more classes (not shown in figure 3) invoking these methods.

In accordance with the general idea of the present invention to compress not all, but only a subset of the methods of an applet that fulfill predefined criteria, step S1 of figure 3 divides the exemplary methods M1, M2, M3 and M4 of the applet 28 into two sets, namely methods that are to be compressed and methods that are not to be compressed. In other words, in step S1 of figure 3 one or more of the exemplary methods M1, M2, M3 and M4 are selected to be compressed. According to preferred embodiments of the invention the selection step S1 can be automated. Alternatively, the step S1 of selecting those methods of the applet 28 that are to be compressed can be performed at least partially by a user, for instance, by the developer of the applet 28.

According to preferred embodiments of the invention, in particular, in case the selection step S1 is automated the predefined criteria that decide whether a method of the applet 28 is to be compressed or not comprise criteria, such as whether a given method is time critical, i.e. has to perform within certain time constraints during runtime, called very frequently by other methods or classes of the applet 28 and/ or provides critical functions implemented in the operating system, such as file handling functions. By way of example, for the applet 28 shown in figure 3 the methods M2 and M4 are selected in step S1 as to be compressed (as indicated by the marker "*") and, consequently, the methods M1 and M3 are not to be compressed.

As part of the selection step S1 of figure 3 the methods to be compressed and/or the methods not to be compressed can be marked accordingly, for instance, by using an appropriate keyword. In the preferred case of the applet 28 being a Java applet in the form of Java byte code such a keyword could be introduced into the respective methods to be compressed (or alternatively the respective methods not to be compressed) by using the conventional Java annotation mechanism known to the person skilled in the art.

In step S2 of figure 3 the applet 28, which is still in the form of source code and which comprises the exemplary methods M1, M2*, M3 and M4* is compiled using an appropriate compiler (in the case of java applet 28 a Java compiler). The result of compiling the applet 28 source code in step S2 of figure 3 is the applet 28 including the methods M1, M2*, M3 and M4* in byte code, which after step S2 of figure 3 are referred to as methods *M1, M2*, M3* and *M4** in figure 3 to highlight the fact that these methods are now in the form of byte code.

According to alternative embodiments of the present invention, steps S1 and S2 of figure 3 could be implemented as a single step, i.e. the selection step S1 could be implemented as part of the compilation step S2. For instance, a compiler could be configured to determine how often a given method is called by other methods and/ or classes of an applet and to mark the given method as "to be compressed" only if it is called by other methods and / or classes less often than a predefined threshold. According to a further preferred embodiment, the compiler could be configured to define a list of critical functions provided by the operating system such that in case a method invokes at least one of these critical OS functions it will be marked as "not to be compressed".

Once the applet 28 source code has been compiled in step S2 of figure 3 and the methods *M1, M2**, *M3* and *M4** are available in the form of byte code the following additional steps according to a preferred embodiment of the present invention will be performed in order to provide the applet 28 in a compressed form on the smart card 20.

Preferably, in step S3 of figure 3 the methods *M1, M2*,* M3 and *M4** in the form of byte code are distributed among different blocks depending on whether the methods *M1, M2*, M3* and *M4** are to be compressed or are not to be compressed in the subsequent step S4 of figure 3. As already described above, by way of example, in the preferred embodiment shown in figure 3 the methods *M2** and *M4** of the applet 28 have been selected in step S1 of figure 3 to be compressed, whereas the methods *M1* and *M3* have not been selected to be compressed. Consequently, in the preferred embodiment shown in figure 3 the methods *M2** and *M4** of the applet 28 are assigned to a first block to be compressed (referred to as "Block 2" in figure 3), whereas the methods *M1* and *M3* are assigned to a second block not to be compressed (referred to as "Block 1" in figure 3). Preferred embodiments of how the methods of an applet, such as the applet 28, can be assigned to or grouped in different blocks will be described in more detail further below.

Once the methods *M2** and *M4** of the applet 28, that have been selected to be compressed in step S1 of figure 3, have been assigned to Block 2, i.e. the block to be compressed, in step S3 of figure 1, any data compression algorithm of a plurality of lossless data compression algorithms known to the person skilled in the art can be used to compress Block 2 including the methods *M2** and *M4** being present in the form of byte code. According to preferred embodiments of the invention the byte code of the methods *M2** and *M4** of Block 2 is compressed using an entropy encoding, preferably Huffman coding. For the preferred case of a lossless data compression in the form of Huffman coding a single Huffman tree can be used for all methods to be compressed.

As a result of the compression step S4 of figure 3, generally, the size of Block 2 including the methods *M2** and *M4** in byte code will be reduced, as indicated in figure 3 by the smaller size of Block 2* (i.e. the compressed Block 2) compared to the uncompressed Block 2 and the free memory space gained by means of the compression step. As in the exemplary embodiment of figure Block 1 is not compressed, the size of Block 1 does not change during the compression step S4.

In step S5 of figure 3 the applet 28, which in the exemplary embodiment shown in figure 3 comprises the methods *M1, M2*, M3* and *M4*,* is stored in the non-volatile memory 24 of the smart card 20 by storing the uncompressed Block 1 including the methods *M1* and *M3* in the form of byte code as well as the compressed Block 2* including the methods *M2** and *M4** in the form of compressed byte code in the non-volatile memory 24 of the smart card 20.

Once the applet 28 has been stored on the smart card 20 it is ready for execution by the virtual machine 26a thereon. Preferably, the virtual machine 26a of the smart card 20 is configured to check, before executing a called method, whether the called method (or the block to which the called method has been assigned) has been compressed. If this is the case, the virtual machine 26a checks whether the block containing the called method already has been uncompressed (for instance because another method belonging to the given block already has been called). If this is the case, the called method is already available in the RAM 23 of the smart card 20 in uncompressed form. Otherwise, the virtual machine 26a uncompresses the block containing the called method and stores the uncompressed block including the called method in the RAM 23. According to preferred embodiments of the invention, the virtual machine 26a keeps track of which blocks of an applet being executed already have been uncompressed (or vice versa which blocks have not been uncompressed yet), for instance, by maintaining an appropriate list. The person skilled in the art will appreciate that the virtual machine 26a can access the methods, which have been stored in uncompressed form in the non-volatile memory 24 of the smart card, such as the exemplary methods *M1* and *M3*, directly in the non-volatile memory, so that these methods do not have to be copied to the RAM 23 of the smart card.

As the person skilled in the art will appreciate, the more uncompressed blocks can be stored or cached in the RAM 23 of the smart card 20 during runtime, the less blocks will have to be uncompressed resulting generally in a better performance. However, the person skilled in the art will appreciate as well that the number of uncompressed blocks that can be stored or cached in the RAM 23 depends on the overall size of the RAM 23.

According to preferred embodiments of the present invention, the blocks to which the methods to be compressed and the methods to be not compressed are assigned in step S3 of figure 3 have the same size. In the exemplary embodiment shown in figure 3 Block 1 containing the methods *M1* and *M3* has the same size as Block 2 containing the methods *M2** and *M4*.*

The person skilled in the art will appreciate that during execution of an applet compressed/ uncompressed blocks within the non-volatile memory 24 of the smart card 20 have a dynamic total size (because the number of compressed and uncompressed blocks may differ from applet to applet), whereas the uncompressed blocks within the RAM 23 have a static, i.e. fixed size. This is advantageous, because managing the RAM 23 is much easier with blocks having a static size. For instance, by using a fixed block size within the RAM 23, a new uncompressed block that has to replace a formerly uncompressed block (or an uncompressed block that has not been compressed in the first place) because the RAM 23 cannot hold any additional uncompressed blocks will replace the old block completely. It is never necessary to move other uncompressed blocks inside the RAM 23 to obtain a portion of the RAM 23 that is large enough to store an uncompressed block. In other words, using a static size for the uncompressed blocks in the RAM 23 has the additional advantage that no garbage collection within the block management of the RAM 23 is required resulting in a better runtime performance.

According to preferred embodiments of the present invention, step S3 of figure 3 of assigning the methods of applet 28 to blocks is done in such a way that a maximum number of method calls during runtime, i.e. "interactions" between methods, stay within the same block or within a minimum number of blocks. In other words, preferably the methods to be compressed are distributed in such a way among the number of necessary blocks that the least number of inter block method calls are required. A good distribution of methods to be compressed among the blocks has the effect that the amount of the RAM 23 necessary to cache uncompressed blocks can be reduced, while maintaining a good runtime performance.

According to preferred embodiments of the invention, one or more methods of an applet, such as the applet 28, that are to be compressed and are called very often by other methods (such as more often than a predefined threshold) can be assigned to and stored in more than one block of the methods to be compressed. In this case, runtime uncompression of another compressed block containing the called method can be avoided, resulting in an improved runtime performance.

According to preferred embodiments of the invention, the step S3 of figure 3 of assigning the methods of applet 28 to blocks includes the additional step of determining an optimal block size. The optimal block size should find the right balance between the block size being so small that during runtime the RAM 23 can be used very flexibly and the block size being so large that the number of blocks that have to be uncompressed because a compressed method within one of these other blocks is called is small.

Given a specific fixed block size, it will often be not possible to fill a block completely with methods to be compressed so that in this case a block will occupy some unused or free memory space. As the person skilled in the art will readily appreciate, for an optimal use of the RAM 23 one should try to leave as few unused memory space as possible. Nevertheless, on a case to case basis it can be advantageous to put the optimization priority on the minimization of the method calls between blocks.

In light of the above detailed description the person skilled in the art will appreciate that modifications and/or additions can be made to the methods and devices as described heretofore, which are to be considered to remain within the scope of the present invention as defined by the appended claims.

## Claims

1. Method of providing a software application (28) in compressed form to a computing device (20), wherein the software application (28) comprises a plurality of methods that can be called from within the software application (28), wherein the method comprises the steps of:
(a) assigning the methods of the plurality of methods to a first set of methods to be compressed and a second set of methods not to be compressed;
(b) compressing the methods of the first set of methods; and
(c) providing the software application (28) in compressed form to the computing device (20), wherein the software application (28) in compressed form comprises the methods of the second set of methods and the methods compressed in step (b).

2. The method of claim 1 comprising before step (b) of compressing the methods of the first set of methods the additional step of compiling the plurality of methods from source code into byte code.

3. The method of claims 1 or 2, wherein step (a) of assigning the methods of the plurality of methods to a first set of methods to be compressed and a second set of methods not to be compressed is done automatically.

4. The method of claim 3, wherein in step (a) the methods of the plurality of methods are assigned to a first set of methods to be compressed and a second set of methods not to be compressed on the basis of predefined criteria, such as whether a given method of the plurality of methods is time critical, i.e. has to perform within certain time constraints during runtime, is called very frequently by other methods or classes of the software application (28) and/ or provides critical functions implemented in an operating system of the computing device (20).

5. The method of claim 1, wherein step (a) of assigning the methods of the plurality of methods to a first set of methods to be compressed and a second set of methods not to be compressed comprises the additional step of assigning the methods of the plurality of methods to one or more blocks to be compressed.

6. The method of claim 5, wherein the one or more blocks to be compressed have the same size.

7. The method of claim 6, wherein the step of assigning the methods of the plurality of methods to one or more blocks to be compressed comprises the additional step of determining an optimal block size.

8. The method of anyone of claims 5 to 7, wherein the methods to be compressed are assigned in such a way to the one or more blocks to be compressed that during runtime the maximum number of method calls are calls to methods within the same block.

9. The method of anyone of claims 5 to 8, wherein a method of the methods to be compressed that is called by other methods of the plurality of methods more often than a predefined threshold is assigned to more than one block of the one or more blocks.

10. The method of anyone of the preceding claims, wherein in step (b) the methods of the first set of methods are compressed using an entropy encoding, preferably Huffman coding.

11. Computing device (20) comprising a software application (28) in compressed form that has been provided to the computing device (20) by one of the methods of the preceding claims.

12. Method of executing a software application (28) on a computing device (20), wherein the software application (28) is stored on the computing device (20) in compressed form and comprises a plurality of methods that can be called from within the software application (28), including a first set of methods in compressed form and a second set of methods in uncompressed form, wherein the method comprises the step of: (a) executing the software application (28) on the computing device (20).

13. The method of claim 12, wherein step (a) of executing the software application (28) on the computing device (20) includes the additional step of uncompressing at least one method of the first set of methods during runtime and storing the at least one method within a RAM (23) of the computing device.

14. The method of claim 12, wherein step (b) of uncompressing at least one method of the first set of methods during runtime and storing the at least one method within a RAM (23) of the computing device is done after the additional step of checking whether the at least one method has already been uncompressed.

15. Computing device (20) that is configured to execute a software application (28) according to one of the methods of claims 12 to 14.
